# EUROPÄISCHE PATENTSCHRIFT

(11) **EP 3 987 577 B1**
(45) Veröffentlichungstag und Bekanntmachung des Hinweises auf die Patenterteilung: **29.04.2026**
(21) Anmeldenummer: 20734499.5
(22) Anmeldetag: 19.06.2020
(51) Int. Cl.: H10K 85/50, H10K 39/15, C07D 209/82, H10K 30/57, H10K 85/20, H10K 30/20, H10K 71/12, H10K 71/16

(54) **PEROWSKIT-MEHRFACHSOLARZELLE MIT MULTISCHICHTSYSTEM ALS VERBINDUNGSSCHICHT**
PEROVSKITE MULTI-JUNCTION SOLAR CELL HAVING MULTI-LAYER SYSTEM AS CONNECTING LAYER
CELLULE SOLAIRE MULTIJONCTION EN PÉROVSKITE COMPORTANT UN SYSTÈME MULTICOUCHE COMME COUCHE DE LIAISON

(30) Priorität: 21.06.2019 DE 102019116851
(43) Veröffentlichungstag der Anmeldung: 27.04.2022
(73) Patentinhaber: Helmholtz-Zentrum Berlin für Materialien und Energie GmbH, 14109 Berlin (DE); Kaunas University of Technology, 44249 Kaunas (LT)
(72) Erfinder: KÖHNEN, Eike, 12555 Berlin (DE); AL-ASHOURI, Amran, 12487 Berlin (DE); JOST, Marko, 10245 Berlin (DE); PROF. DR. ALBRECHT, Steve, 14542 Werder Havel (DE); MAGOMEDOV, Artiom, 44156 Kaunas (LT); GETAUTIS, Vytautas, 51390 Kaunas (LT); ROSS, Marcel, 12437 Berlin (DE); KEGELMANN, Lukas, 12055 Berlin (DE); MALINAUSKAS, Tadas, 49317 Kaunas (DE)
(74) Vertreter: Schulz Junghans Patentanwälte PartGmbB
(86) Internationale Anmeldenummer: PCT/EP2020/067252
(87) Internationale Veröffentlichungsnummer: WO 2020/254665

(56) Entgegenhaltungen:
- MARKO JOST ET AL: "21.6%-Efficient Monolithic Perovskite/Cu(In,Ga)Se 2 Tandem Solar Cells with Thin Conformal Hole Transport Layers for Integration on Rough Bottom Cell Surfaces", ACS ENERGY LETTERS, vol. 4, no. 2, 24 January 2019 (2019-01-24), pages 583 - 590, XP055720784, ISSN: 2380-8195, DOI: 10.1021/acsenergylett.9b00135
- ARTIOM MAGOMEDOV ET AL: "Self-Assembled Hole Transporting Monolayer for Highly Efficient Perovskite Solar Cells", ADVANCED ENERGY MATERIALS, vol. 8, no. 32, 21 September 2018 (2018-09-21), DE, pages 1801892, XP055720804, ISSN: 1614-6832, DOI: 10.1002/aenm.201801892
- DEIMANTE VAITUKAITYTE ET AL: "Efficient and Stable Perovskite Solar Cells Using Low-Cost Aniline-Based Enamine Hole-Transporting Materials", ADVANCED MATERIALS, vol. 30, no. 45, 24 September 2018 (2018-09-24), pages 1803735, XP055721160, ISSN: 0935-9648, DOI: 10.1002/adma.201803735

## Beschreibung

### Stand der Technik

Solarzellen mit einer Metall-Halogenid Perowskit-Absorptionsschicht (Perowskite) haben in auffallend kurzer Zeit erstaunliche Wirkungsgrade von über 24% der Leistungsumwandlung (Power conversion efficiency; PCE) überschritten, wie auch der, unter der Bezeichnung "NREL efficiency chart" (https://www.nrel.gov/pv/assets/pdfs/best-research-cell-efficiencies-190416.pdf, abgerufen am 18.06.2019) bekannten Übersicht zu entnehmen ist. Durch die optisch anpassbare Bandlücke und die hohen Wirkungsgrade sind Perowskit-Absorberschichten der ideale Partner für die Tandemintegration als Topzelle (Licht zugewandte Teil-Solarzelle in der Tandemsolarzelle) mit Bottomzellen (Licht abgewandte Teilzelle in der Tandemsolarzelle) aus verschiedenen Materialien. Beispiele für Bottomzellen in Perowskit-Tandemsolarzellen aus Silizium finden sich in dem Aufsatz 1 von J.P. Mailoa et al. (Appl. Phys. Lett., 106, 2015, 121105 - 1-4), aus Kupfer-Indium-Gallium-Selenid (engl. Copper-Indium-Gallium-Diselenid; CIGSe, dt. Kupfer-Indium-Gallium-Diselenid) in dem Aufsatz 2 von T. Todorov et al. (Adv. Energy Mater., 5, 2015, 1-6) und aus Sn-basierten Perowskiten in dem Aufsatz 3 von G.E. Eperon et al. (Science, 354, 2016, 861-865). Seit 2015 wird intensiv an diesen Tandemarchitekturen geforscht und es wurden im Jahr 2018 sehr vielversprechende Ergebnisse mit Perowskit/Silizium, Perowskit/CIGSe und Perowskit/Perowskit Tandemsolarzellen veröffentlicht, wie dem Überblicksartikel von Y Hu et al., Aufsatz 4, (Sol. RRL, 2019, 1900080 - 1-21) zu entnehmen ist. Üblicherweise wird als Verbindungsschicht zwischen den beiden Teil-Solarzellen der Perowskit-Tandemsolarzellen ein transparentes leitfähiges Oxid (TCO) verwendet, worauf die Perowskit-Topzelle meist durch Aufschleudern prozessiert wird. Für raue Oberflächen, wie z.B. texturiertes Silizium oder raues CIGSe müssen entsprechende Verfahren zur Abscheidung der Kontaktschichten und des Perowskits verwendet werden, welche die Substratoberfläche vollständig bedecken, um Kurzschlüsse zu vermeiden. Als raue Oberflächen eingeschlossen sind dabei texturierte und zufällig texturierte Oberflächen, sowie als Grenzfall auch polierte Oberflächen. Die Perowskit-Absorberschicht selbst ist mit einer Schichtdicke von ca. 500 nm dick genug um bestimmte Oberflächenrauheiten vollständig zu bedecken oder kann mit konformen Wachstumsverfahren wie thermisches Verdampfen oder hybriden Prozessen in Kombination aus Lösungs- und Vakuumverfahren aufgebracht werden, wie es z.B. in dem Aufsatz 5 von F. Sahli et al. (Nature Materials, 17, 2018, 820-826) beschrieben ist. "Konform" meint hierbei die vollständige, der Substratgeometrie mikroskopisch folgende Abdeckung unter Vermeidung jeglicher Unterbrechung, die zu einem elektrischen Kurzschluss führen könnte.

Speziell die Abscheidung der ladungsselektiven Kontaktschichten, welche für effiziente Perowskit-Solarzellen benötigt werden, ist komplex. In hocheffizienten Perowskit-Solarzellen sind diese Schichten eher im Bereich von einigen 10 nm dick und somit schwieriger auf rauen Oberflächen konform abzuscheiden. Bringt man sie etwa auf eine raue CIGSe-Oberfläche auf, so entstehen in der Tandemsolarzelle Kurzschlüsse, wie in dem Aufsatz 6 von M. Jost et al. (ACS Energy Lett., 4, 2019, 583-590) dargestellt. Eine bereits demonstrierte Möglichkeit ist die Abscheidung der dünnen, zumeist organischen Kontaktschichten mittels thermischen Verdampfens. Hierbei ist man allerdings in der Wahl der prozessierbaren Moleküle sowie Haftschichten und damit auch in der Effizienz limitiert. Eine weitere Methode ist die konforme Abscheidung sehr dünner Kontaktschichten von zumeist Metalloxiden mittels ALD (atomic layer deposition, Atomlagenabscheidung). Hierbei wird häufig NiOx als Kontaktschicht verwendet, was wiederum eine limitierte Effizienz zeigt (ebd.). Eine andere Methode ist die mechanische Glättung der z. B. TCO Oberfläche durch Polieren, sodass anschließend auch dünne Schichten mittels Schleuderbeschichtung aufgebracht werden können, was in dem Aufsatz 7 von Q. Han et al. (Science, 361, 2018, 904-908) aufgezeigt wird. Dieses komplexe Verfahren hat jedoch den Nachteil, dass die TCO Schichten sehr dick (~einige hundert nm) prozessiert werden müssen, sodass eine vollständige Bedeckung nach dem Polieren gegeben ist. Dadurch ist der Gesamtprozess mit hohen Kosten verbunden.

Neben Tandemsolarzellen, mit denen hier die Kombination von zwei Teil-Solarzellen gemeint ist, sind auch Mehrfachsolarzellen mit mehr als zwei Teil-Solarzellen (Dreifachsolarzelle, Vierfachsolarzelle, etc.) realisiert. Die Tandemsolarzelle ist dabei auch eine Mehrfachsolarzelle. In Mehrfachsolarzellen wird eine vom Lichteinfall abgewandte Teil-Solarzelle als Bottomzelle angesprochen und die dem Lichteinfall zugewandte ("oberste") Teil-Solarzelle als Topzelle. Die im Folgenden als Perowskit-Mehrfachsolarzellen angesprochenen Mehrfachsolarzellen umfassen dabei mindestens eine Teil-Solarzelle, deren Absorberschicht auf Perowskit basiert. Eine oder mehrere in einer Mehrfachsolarzelle befindliche Teil-Solarzellen, die in einem Stapel von Teil-Solarzellen und bezogen auf die Lichteinfallsrichtung direkt oder nicht direkt zuunterst (lichtabgewandt) angeordnet als Bottomzelle oder zuoberst (lichtzugewandt) angeordnet als Topzelle ansprechbar sind, sind im Sinne dieser Beschreibung im Folgenden, in Bezug auf ihre relative Lage zu einer Verbindungsschicht, ebenfalls als Bottomzelle (im Stapel unterhalb der Verbindungsschicht, in Bezug auf die Lichteinfallsrichtung) oder Topzelle (im Stapel oberhalb der Verbindungsschicht) anzusprechen.

Als Silizium Teil-Solarzellen sind hier Solarzellen angesprochen, deren Absorberschicht auf Siliziumoxid oder Silizium, inklusive amorpher, nano- oder multikristalliner, Wasserstoff-dotierter und oxydischer auf Silizium basierter Absorberschicht und hier insbesondere a-Si:H, nc-Si:H, a-SiOx:H, nc-SiOx:H, µc-Si:H, µc-SiOx:H basiert. Die Aufzählung ist nicht abschließend.

Perowskit-basierte Solarzellen können durch ihre breite Bandlücken-Anpassung sowohl als Topzelle als auch als Bottomzelle verwendet werden. Der Begriff "Perowskit" im Sinne dieser Beschreibung bezieht sich auf die "Perowskit-Struktur" und nicht speziell auf das Perowskit-Material CaTiO₃. Für die Zwecke dieser Beschreibung schließt "Perowskit" jedes Material ein und bezieht sich vorzugsweise auf jedes Material, das den gleichen Kristallstruktur-Typ wie Calciumtitanoxid aufweist und auf Materialien, bei denen das zweiwertige Kation durch zwei getrennte einwertige Kationen ersetzt ist. Die Perowskitstruktur weist die allgemeine Stöchiometrie AMX₃ auf, wobei "A" und "M" Kationen sind und "X" ein Anion ist. Die Kationen "A" und "M" können verschiedene Ladungen aufweisen und im ursprünglichen Perowskit-Mineral (CaTiO₃) ist das A-Kation zweiwertig und das M-Kation vierwertig. Für die Zwecke dieser Erfindung umfassen die Perowskit-Formeln Strukturen mit einem (1), zwei (2), drei (3) oder vier (4) Kationen, die gleichartig oder verschieden sein können, und/oder ein oder zwei (2) Anionen und/oder Metallatome, die zwei oder drei positive Ladungen tragen, gemäß den an anderer Stelle in dieser Beschreibung angegebenen Formeln.

Ferner wird bevorzugt, dass das organisch-anorganische Perowskit-Material eine Perowskit-Struktur einer der nachstehenden Formeln aufweist. Dabei kann der Perowskit sowohl mittels nass-chemischer (Schleuderbeschichtung oder Druckverfahren) als auch trockenen Prozessen mittels Vakuumabscheidung durch z.B. Ko-verdampfen abgeschieden werden:

A¹A²A³A⁴MX₃, A¹A²A³MX₃, A¹A²MX₄ ; A¹MX₃ ; A¹A²N_{2/3}X₄; A¹N_{2/3}X₃ ; BN_{2/3}X₄ ; A¹₂NMX₆; BMX₄,

wobei
- A¹, A², A³,A⁴ entweder organische einwertige Kationen oder Mischungen davon sind, die unabhängig voneinander aus primären, sekundären, tertiären oder quaternären organischen Ammoniumverbindungen, einschließlich N-haltiger Heteroringe und Ringsysteme ausgewählt sind. A und A' weisen dabei unabhängig voneinander 1 bis 60 Kohlenstoffatome und 1 bis 20 Heteroatome (wie etwa Methylammonium oder Formamidinium) oder anorganische Kationen (wie etwa Na, K, Rb, Cs) auf.
- B ein organisches, zweiwertiges Kation ist, ausgewählt aus primären, sekundären, tertiären oder quaternären organischen Ammoniumverbindungen, die 1 bis 60 Kohlenstoffatome und 2 bis 20 Heteroatome aufweisen und mit zwei positiv geladenen Stickstoffatome;
- M ein zweiwertiges Metallkation ist, ausgewählt aus der Gruppe, bestehend aus Cu²⁺, Ni²⁺, Co²⁺, Fe²⁺, Mn²⁺, Cr²⁺, Pd²⁺, Cd²⁺, Ge²⁺, Sn²⁺, Pb²⁺, Eu²⁺ oder Yb²⁺;
- N ausgewählt ist aus der Gruppe von Bi³⁺ und Sb³⁺; und,
- X unabhängig ausgewählt ist aus Cl⁻, Br⁻, I⁻, NCS⁻, CN⁻ und NCO⁻. X kann ebenfalls eine Mischung aus den aufgeführten Halogeniden/Anionen sein.

Neben Silizium und Perowskit-basierten Bottomzellen bieten sich auch Dünnschichtsolarzellen aus Kupfer-Indium-Gallium-Diselenid (CIGSe) und Kupfer-Indium-Diselenid (CIS) an. CIGSe bezeichnet dabei das Absorber-Material mit der Formel CuIn₁₋ₓGaₓSe₂ (mit x = 0 bis 1) und ist ein I-III-VI-Verbindungshalbleiter mit einer von x abhängigen Bandlücke von 1 bis 1.7 eV.

### Zusammenfassung der Erfindung

Die Aufgabe der Erfindung ist es, ein Multischichtsystem als Verbindungsschicht für die Verwendung in Perowskit-Mehrfachsolarzellen anzugeben, wobei die Verbindungsschicht eine ladungsselektive Kontaktschicht umfasst, die ungeachtet der Rauheit einer Oberfläche konform aufbringbar ist. Darüber hinaus ist es die Aufgabe der Erfindung hohe Leistungsumwandlungseffizienzen von Mehrfachsolarzellen, minimalen Materialverbrauch, minimale parasitäre optische Absorption, Skalierbarkeit bzw. Kompatibilität zu großflächiger Prozessierung und Abwesenheit von Dotierungen, welche die Stabilität der Perowskit-Teil-Solarzelle beeinflusst, zu ermöglichen.

Als konform im Sinne der Erfindung ist eine Bedeckung einer Schicht mit einer anderen Schicht anzusehen, wenn die abdeckende Schicht die Textur der zu bedeckenden Schicht gleichförmig abdeckt, so dass die Schichtdicke der abdeckenden Schicht an jedem Punkt gleich ist und die Textur der abzudeckenden Schicht dadurch wiederum 1:1 auf der Oberfläche der abdeckenden Schicht reproduziert ist. Die abdeckende Schicht liegt dabei ohne Unterbrechungen vor.

Die Erfindung umfasst dabei eine Mehrfachsolarzelle, welche mindestens eine Perowskit-Teil-Solarzelle umfasst und ein Multischichtsystem, welches mindestens eine Schicht A und eine Schicht B umfasst. Die Schicht A ist dabei entsprechend den unten gemachten Ausführungen, betreffend die Molekülart und Ausbildung einer selbstorganisierten Monolage, direkt auf der Schicht B aufgebracht. Die Schicht B ist entsprechend den unten gemachten Ausführungen, betreffend das Material aus dem die Schicht gebildet ist, ausgebildet und direkt auf die oberste Schicht einer als Bottomzelle anzusprechenden Teil-Solarzelle der Mehrfachsolarzelle aufgebracht. Die Perowskit-Teil-Solarzelle der Mehrfachsolarzelle ist wiederum direkt auf die Schicht A aufgebracht (wobei Schicht A hierbei den Loch-selektiven Kontakt der Perowskit-Teil-Solarzelle darstellt).

Das Multischichtsystem besteht demnach aus mindestens zwei einzelnen Schichten, Schicht A und Schicht B, wobei Schicht A direkt und konform auf Schicht B aufgebracht ist, und so als elektrische Verbindungsschicht in Perowskit-Mehrfachsolarzellen einsetzbar ist. Das Multischichtsystem als Verbindungsschicht besteht dabei aus einer, auch als Substratschicht ansprechbaren Schicht B und einem direkt darauf aufgebrachten lochleitenden Material, das für eine Selbstorganisierung als Monolage auf der Oberfläche der Schicht B konfiguriert ist und die Schicht A bildet. Das lochleitende Material liegt dabei als Molekülmonolage vor und dient als Loch-selektive Kontaktstruktur für eine darauf aufgebrachte Perowskit-Absorberschicht und ermöglicht, gegenüber dem aus dem Stand der Technik bekannten, erhöhte Leerlaufspannungen und Effizienzen. Die Molekülmonolage der Schicht A ist dabei konform zur Schicht B, auf die diese aufgebracht ist.

Die Schicht B ist gebildet aus mindestens einem der Materialien aus der Gruppe Indium-, Zink-, Zinn, Nickel-, Kupfer, Wolfram- und Molybdän- Oxid, Siliziumoxid, Silizium, inklusive amorpher, nano- oder multikristalliner, Wasserstoff-dotierter und oxydischer Schichten, insbesondere a-Si:H, nc-Si:H, a-SiOx:H, nc-SiOx:H, µc-Si:H, µc-SiOx:H. Die Schicht B befindet sich dabei als Teil des Multischichtsystems, welches als Verbindungsschicht in Mehrfachsolarzellen fungiert, insbesondere auf der obersten Schicht einer als Bottomzelle anzusprechenden Teil-Solarzelle einer Mehrfachsolarzelle. Schicht B ist in der Mehrfachsolarzelle eine geteilte Elektrode beider, durch das Multischichtsystem verbundener Teil-Solarzellen. Schicht A ist Teil der auf Schicht B als Topzelle prozessierten Teil-Solarzelle. Die im Folgenden verwendete Formulierung, dass das Multischichtsystem als Verbindungsschicht zwischen Teil-Solarzellen fungiert, schließt mit ein, dass die Komponenten der Verbindungsschicht selbst auch Komponenten der Teil-Solarzellen sein können.

Schicht A ist erfindungsgemäß aus mindestens einer Molekülart gemäß der Formel (I) gebildet, das als HTM (Hole Transporting Material; deutsch: lochleitendes Material) fungiert: 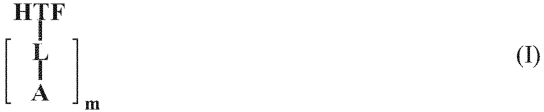
wobei m = 1 bis 2, L ein verbindendes Fragment, A eine Ankergruppe und HTF ein lochleitendes Fragment ist (engl. hole transporting fragment, lochleitendes Fragment), das aus einer der folgenden Formeln (II) oder (III) ausgewählt ist,
einem Polyzyklus

   Z-D-Z, (II)
wobei Formel (II) ausgewählt ist aus mindestens einer der Formeln IV bis XIII wie unten definiert; oder 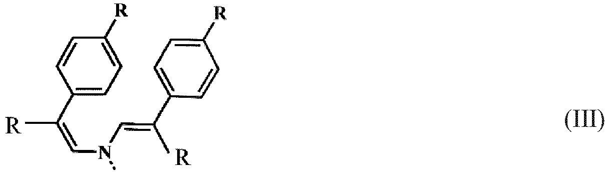
und R ein Substituent ist.

Die erfindungsgemäße Schicht A, gebildet aus einer selbstorganisierten Monolage (engl. *self-assembled monolayer,* SAM) einer Molekülart gemäß der Formel (I), fungiert aufgrund der Elektronenlokalisation als lochleitendes Material. Für diesen Zweck werden Molekülarten, die eine Elektronenlokalisierung über das gesamte System ermöglichen, bevorzugt. Insbesondere die Delokalisation zwischen den Z-Fragmenten über das Fragment D ist hierbei bevorzugt. Daher ist D wie aus Formeln IV bis XIII ersichtlich ein aromatisches Fragment und/oder ein Element mit elektronenabstoßendem (electron pushing) Charakter, das in Verbindung mit den Fragmenten Z steht. Insbesondere bevorzugt werden symmetrische Strukturen, d. h. Molekülarten, die entlang einer Achse gespiegelt werden können. Spiegelung bezieht sich auf die schematische Struktur und nicht unbedingt auf das eigentliche sterische Erscheinungsbild. Es ist von Vorteil, dass die Spiegelachse durch die Komponente D verläuft, sodass die beiden Z-Komponenten gleich oder invers sind. Eine wichtige Eigenschaft, um hohe Leistungsumwandlungseffizienzen in der Mehrfachsolarzelle zu erreichen, ist die chemische und energetische Kompatibilität der SAM zur Perowskit-Schicht. Durch passenden Entwurf der genutzten Moleküle kann das Ionisationspotenzial bzw. das höchste besetzte molekulare Orbital so eingestellt werden, dass zwischen diesem und der Valenzbandkante des Perowskits kein energetischer Versatz vorhanden ist, der die Leerlaufspannung der Solarzelle beeinträchtigt.

Für die Bildung einer SAM kann die Molekülart gemäß der Formel (I) mit anderen funktionalen Molekülen, sogenannten "Füllstoffmolekülen" (FM), vermischt werden. Ein FM ist im Allgemeinen eine Molekülart oder eine Mischung von Molekülarten, die aus einer Ankergruppe (z. B. Phosphonsäure, Phosphorsäure, Schwefelsäure, Sulfonsäure, Carbonsäure, Siloxane), die an die Oberfläche der TCO binden kann, einer Alkylkette mit N Kohlenstoffatomen, wobei N = 1 bis 18 ist und einer funktionellen Methyl-, Halogen-, Amino-, Bromid-, Ammonium- und/oder Schwefelgruppe gebildet ist. Beispiele sind Ethyl- oder Butylphosphonsäure ("C2" oder "C4") oder (Aminomethyl)phosphonsäure. Die FM fungieren als Passivierungsmittel, das die Ladungsträgerrekombination zwischen dem TCO und dem Perowskit reduziert, sowie als ein Mittel zur Modifizierung der Benetzbarkeit des TCO.

In bevorzugten Ausführungsformen der Erfindung ist D eine C₅- oder C₆-heteroaromatische Gruppe, wobei das Heteroatom N, Si, S und/oder O ist.

Wie beansprucht ist das lochleitende Fragment (HTF) aus einem der in den Formeln (IV) bis (XIX) angegebenen Strukturen ausgewählt.

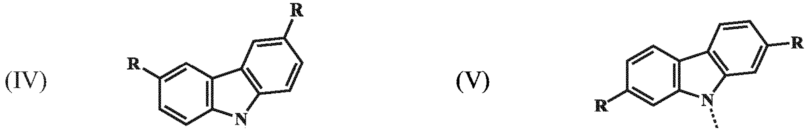

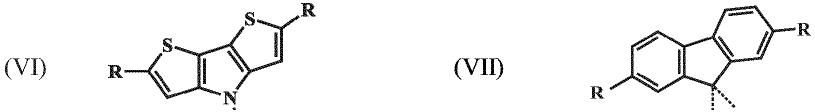

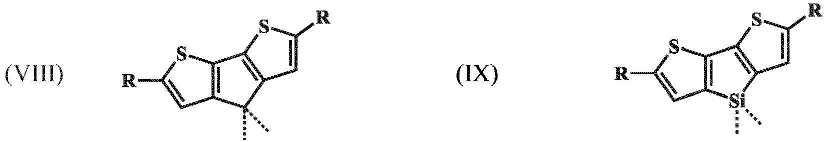

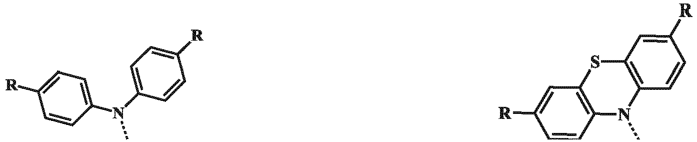

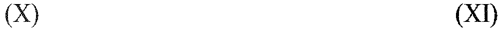

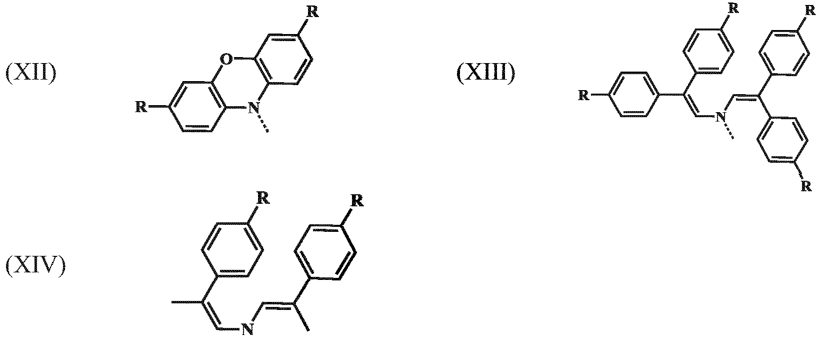

Gruppen R werden ausgewählt aus Wasserstoff oder 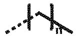 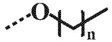 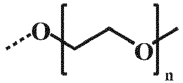 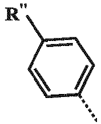 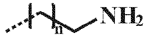 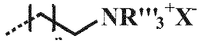 wobei
n = 1 bis 12 und die gestrichelten Linien die Bindung darstellen, durch die R mit dem HTF gemäß Formel (II) oder (III) verbunden ist, X Halogen (F, Cl, Br, I) darstellt;
R‴ Wasserstoff, Alkyl (C₁ bis C₁₂) darstellt und/oder R" Wasserstoff, Alkyl, Alkoxy (-CH₃; -OCH₃) darstellt.

In weiteren Ausführungsformen ist das verbindende Fragment L eines, das ausgewählt ist aus C₁- bis C₉-Alkylen, C₄- bis C₂₀-Arylen, C₄- bis C₂₀-Heteroarylen, C₄- bis C₂₀-Alkylarylen, C₄-bis C₂₀-Heteroalkylarylen, wobei die Heteroatome ausgewählt sind aus O, N, S, Se, Si und wobei die genannten Alkylene, Arylene, Heteroarylene, Alkylarylene, Heteroalkylarylene, Heteroalkylarylene, wenn sie drei oder mehr Kohlenstoffatome umfassen, linear, verzweigt oder cyclisch sein können, insbesondere ausgewählt aus einem von 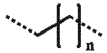 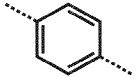 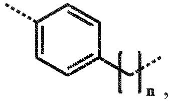 wobei
n = 1 bis 12 und die gestrichelten Linien die Bindung darstellen, durch die L mit dem HTF gemäß Formel II oder III verbunden ist.

In bevorzugten Ausführungsformen ist die Ankergruppe A (Kopfgruppe) ausgewählt aus Phosphonsäure, Phosphorsäure, Schwefelsäure, Sulfonsäure, Carbonsäure, Siloxanen, insbesondere ausgewählt aus einem von 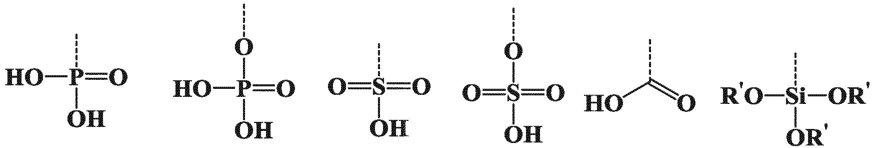 wobei
die gestrichelten Linien die Bindung darstellen, durch die A mit L gemäß einem der vorhergehenden Ansprüche verbunden ist und R' vorzugsweise aliphatisch ist.

Vorzugsweise ist die Mehrfachsolarzelle eine aus der Gruppe Silizium/Perowskit (mit planarer oder texturierter Oberfläche der Silizium-Teil-Solarzelle), CIGSe/Perowskit, Perowskit/Perowskit. Aber auch Dreifachsolarzellen oder andere Mehrfachsolarzellen mit mindestens einer Perowskit-Teil-Solarzelle sind möglich.

Ein weiterer Aspekt der vorliegenden Erfindung ist die Verwendung des erfinderischen Multischichtsystems als elektrische Verbindung in einer optoelektronischen und/oder photoelektrischen Vorrichtung.

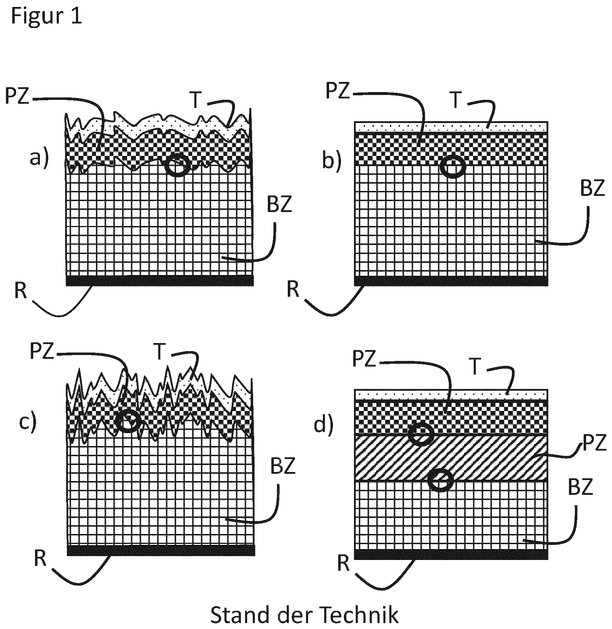

Das Verfahren zur Bildung des erfinderischen Multischichtsystems für die Verwendung in Perowskit-basierten Mehrfachsolarzellen (in den in Figur 1 gezeigten Architekturen) ist durch ein Verfahren gegeben, das konsekutiv die folgenden Schritte umfasst.

Erstens in Schritt a) das Bereitstellen einer Schicht B, gebildet aus mindestens einem der Materialien der Gruppe Indium-, Zink-, Zinn-, Nickel-, Kupferoxid oder Mischungen davon; oder Siliziumoxid oder Silizium, inklusive amorpher, nano- oder multikristalliner, Wasserstoff-dotierter und oxydischer Schichten, insbesondere a-Si:H, nc-Si:H, a-SiOx:H, nc-SiOx:H, µc-Si:H, µc-SiOx:H; vorzugsweise TCO oder oxidhaltiges nanokristallines Silizium. Diese Schicht B ist dabei auch als Substratschicht anzusprechen und befindet sich dabei als Teil des Multischichtsystems, welches als Verbindungsschicht in Mehrfachsolarzellen fungiert, auf der obersten Schicht einer als Bottomzelle anzusprechenden Teil-Solarzelle der Tandemsolarzelle.

Im folgenden Schritt b) erfolgt die Beschichtung der Schicht B mit einer Schicht A. Die Schicht A ist dabei gebildet aus mindestens einer Molekülart gemäß der Formel (I): 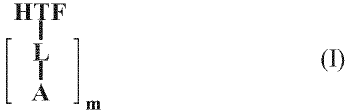
wobei m = 1 bis 2, L ein verbindendes Fragment, A eine Ankergruppe und HTF ein lochleitendes Fragment ist, das aus einer der folgenden Formeln II oder III ausgewählt ist,

   einem Polyzyklus Z-D-Z, (II),
wobei Formel (II) ausgewählt ist aus mindestens einer der Formeln IV bis XIII wie oben definiert; oder 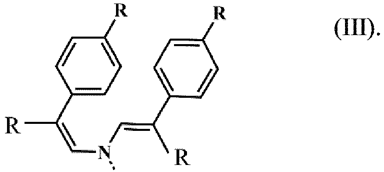
wobei R ein Substituent ist. Aufgrund der Molekülstruktur bilden die Molekülarten gemäß Formel (I) selbstorganisierte Monolagen.

Die Beschichtung erfolgt nach einem der Verfahren aus der folgenden Gruppe.
- Eintauchen der Schicht B in eine Lösung, die ein Lösungsmittel und Moleküle mindestens einer Molekülart gemäß der Formel (I) enthält. Das Eintauchen der Schicht B umfasst dabei gegebenenfalls auch das Eintauchen aller anderen, sich bereits unter der Schicht B befindlichen Schichten. Als Lösungsmittel für die Lösung kann jede Flüssigkeit gewählt werden, die in der Lage ist, die Verbindung zu lösen und das Eintauchen einer Oberfläche garantiert. Die Konzentration der Verbindung in der Lösung liegt vorzugsweise im Bereich von 0,01 mM bis 100 mM pro Liter. Die Zeit für das Eintauchen der Oberfläche zur Bildung der SAM sollte mindestens ausreichend sein, damit sich die Moleküle an die Oxidoberfläche binden können und sie liegt vorzugsweise im Bereich von 1 s bis 20 Stunden. Nach dem Eintauchen wird das Substrat aus dem Lösungsmittel entfernt. Eine kurze Dauer der Eintauchzeit wird z.B. auch im sog. "T-BAG"-Verfahren verwendet, gekennzeichnet durch kurzes Eintauchen mit langsamen Herausziehen, wobei sich die SAM-Ordnung am "Meniskus" der Lösung beim Trocknen bildet. Ein derartiges Tauchverfahren ist insbesondere für den Einsatz im sogenannten Rolle-zu-Rolle-Verfahren interessant.
- Aufschleudern einer Lösung, die ein Lösungsmittel und mindestens eine Molekülart gemäß der Formel (I) enthält auf die Schicht B. Die Lösung ist von derselben Art und Konzentration wie für das Eintauch-Verfahren. Die Rotationsgeschwindigkeit für die Beschichtung befindet sich im Bereich von 1-10000 Umdrehungen pro Minute. Die verwendete Menge an Lösung muss ausreichend für das zu beschichtende Substrat sein; etwa eignet sich für ein 25 x 25 mm großes Substrat eine Menge von 10 - 100 µl. Die genauen Parameter müssen je nach Rahmenbedingungen, wie etwa verwendeter Perowskit oder verwendetes Substrat, experimentell angepasst werden.
- Aufdrucken einer Lösung, die ein Lösungsmittel und mindestens eine Molekülart gemäß der Formel (I) enthält, auf die Schicht B. Auch hierbei lehnt sich die Art und Konzentration der Lösung an die des Eintauch-Verfahrens an und muss je nach Druck-Verfahren und weiteren Rahmenbedingungen experimentell angepasst werden. Mögliche Druck-Verfahren sind dabei insbesondere der Tintenstrahldruck, das Schlitzdüsendrucken oder Rakeln aus einer Düse. Das jeweils optimale Verfahren für die gewählte Molekülart gemäß Formel (I) und Schicht B sowie die ideale Konzentration der Molekülart in der Lösung ist bei Bedarf experimentell zu bestimmen.

Das so entstandene Multischichtsystem, bestehend aus Schicht A und Schicht B, wird in einem Schritt c) -unabhängig vom Verfahren der Beschichtung in Schritt b)- anschließend thermisch ausgeheizt und/oder gewaschen. Für das Ausheizen vorteilhaft ist eine Temperatur von 20-300 °C und eine Zeit von 1 min bis 50 h. Das Ausheizen und Waschen sind dabei jeweils optional und nicht für jede Molekülart notwendig, um das Multischichtsystem zu erhalten.

Das erfindungsgemäße Multischichtsystem löst dabei die in der Einleitung erwähnten Schwierigkeiten der Realisierung von Mehrfachsolarzellen mit vor allem rauen Oberflächen. Es verbindet hohe Solarzell-Effizienzen mit den Vorzügen dünner organischer Loch-selektiver Kontakte (hohe Ladungsextraktions-Effizienz, kleiner Materialverbrauch, geringe Kosten, Kompatibilität zum Perowskit) und der Möglichkeit jegliche Substrat-Beschaffenheit bzw. deren Textur konform zu bedecken. Zusätzlich stellt die Erfindung im Hinblick auf Massenfertigung von Solarzellen eine skalierbare Methode dar.

### Ausführungsbeispiele

Die Erfindung soll anhand von Ausführungsbeispielen eines erfindungsgemäßen Multischichtsystems, dessen Herstellung und einer Perowskit-Mehrfachsolarzelle mit dem Multischichtsystem als Verbindungsschicht sowie fünf Figuren näher erläutert werden.

Die Figuren zeigen:
**Figur 1****:** Schematischer Aufbau (nicht maßstabsgetreu) der gängigen, zum Stand der Technik gehörenden Architekturen von Perowskit-Mehrfachsolarzellen mit PZ: Perowskit-Teil-Solarzelle; BZ: Bottomzelle, R: Rückkontakt; T: Topkontakt; a) Tandemsolarzelle mit Perowskit-Teil-Solarzelle PZ und CIGSe-Bottomzelle BZ; b) Tandemsolarzelle mit Perowskit-Teil-Solarzelle PZ und Perowskit-Bottomzelle BZ oder einer Bottomzelle BZ aus poliertem Silizium; c) Tandemsolarzelle mit Perowskit Teil-Solarzelle PZ und Bottomzelle BZ aus texturiertem Silizium und d) Dreifachsolarzelle mit zwei Perowskit-Teil-Solarzellen PZ und einer Silizium-Bottomzelle BZ. Zusätzlich ist die Lage der Verbindungsschichten in den Tandemsolarzellen und der Dreifachsolarzelle mit einem Kreis markiert.

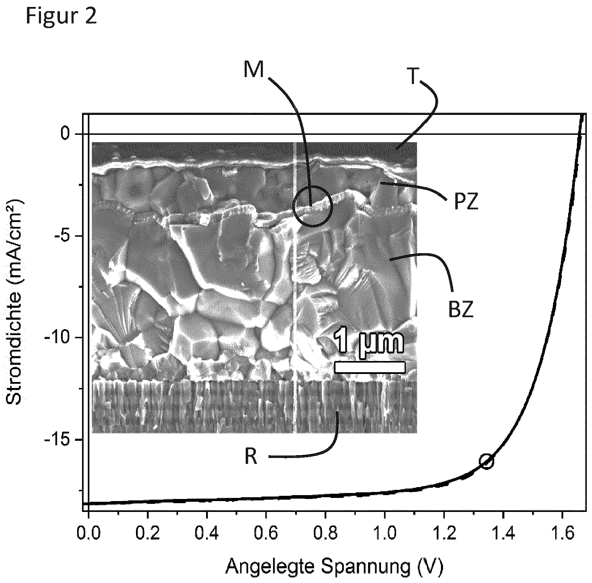

**Figur 2****:** Strom-Spannungskurve einer monolithischen Tandemsolarzelle mit einer Bottomzelle BZ aus CIGSe und einer Perowskit-Teil-Solarzelle PZ, sowie Rückkontakt R aus Molybdän und einem Topkontakt T aus TCO. Die Leistungsumwandlungseffizienz der Tandemsolarzelle beträgt 21,6 % (aktive Fläche ~ 0.78 cm², der Kreis auf der Kennlinie gibt den sogenannten "maximum power point", wieder). Zusätzlich gezeigt ist die elektronenmikroskopische Abbildung eines Querschnitts durch die CIGSe/Perowskit-Tandemsolarzelle. Das Multischichtsystem M (Lage durch einen Kreis zusätzlich gekennzeichnet) im Umfang der Erfindung besteht im Beispiel aus einem transparenten leitfähigen Oxid als Schicht B gebildet aus Aluminium-dotiertem Zinkoxid (AZO) und einem SAM basierend auf der Molekülart "V1193" (siehe weiter unten im Text) als Schicht A, welche direkt auf die Schicht B aufgebracht ist.

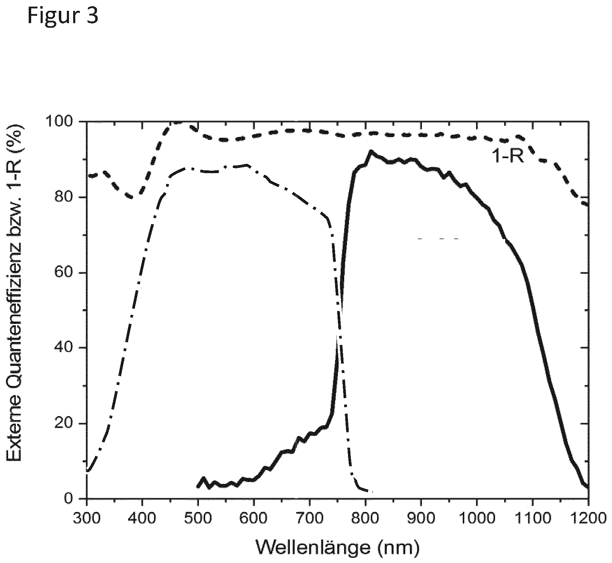

**Figur 3****:** Externe Quanteneffizienz (durchgehende Linie: CIGSe Bottomzelle; strichpunktierte Linie: Perowskit-Teil-Solarzelle) beider Teil-Solarzellen der in Figur 2 gezeigten Tandemsolarzelle. Dabei ist die Stromdichte für die CIGSe-Bottomzelle 18,24 mA/cm² und die Perowskit-Teil-Solarzelle 19,65 mA/cm², (Werte aus einer Integration des Produkts der externen Quanteneffizienz und dem AM1.5G Solar-Spektrum). Die gestrichelte Linie zeigt eine Messung der optischen Reflektion (1-R) der Tandemsolarzelle.

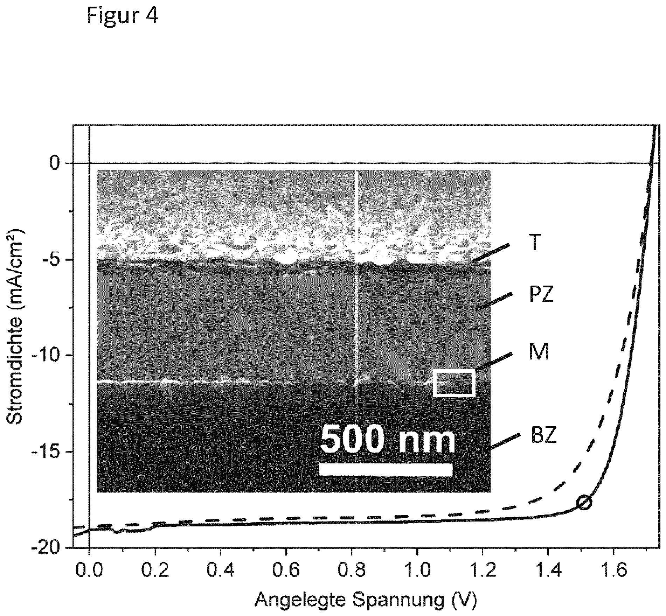

**Figur 4****:** Stromdichte-Spannungs-Kennlinie (- Vorwärts-Scan, --- Rückwärts-Scan) einer Silizium/Perowskit Tandem-Solarzelle mit polierter Si-Oberfläche und Perowskit aus Vakuum-Abscheidung und elektronenmikroskopisches Bild des Querschnitts der Solarzelle. Der Kreis auf der Kennlinie gibt den "maximum power point" an, der durch 5-minütige Leistungsverfolgung (engl. *maximum power point tracking)* erhalten wurde, und welcher die stabilisierte Leistungsumwandlungseffizienz von ca. 26,6 % angibt. Die elektronenmikroskopische Aufnahme zeigt die glatte Oberfläche der polierten Silizium-Bottomzelle (BZ, nicht vollständig sichtbar im Bild), auf der ITO und V1193 (zusammen Multischichtsystem M) prozessiert sind. Durch die Schicht A (SAM V1193) kann der aufgedampfte Perowskit (PZ) kristallin und säulenartig auf dem Substrat wachsen. T bezeichnet im Bild den Top-Kontakt bestehend aus C60, SnOx, IZO, Ag, LiF (ein zugehöriger Ag-Rahmen ist im Bild nicht sichtbar).

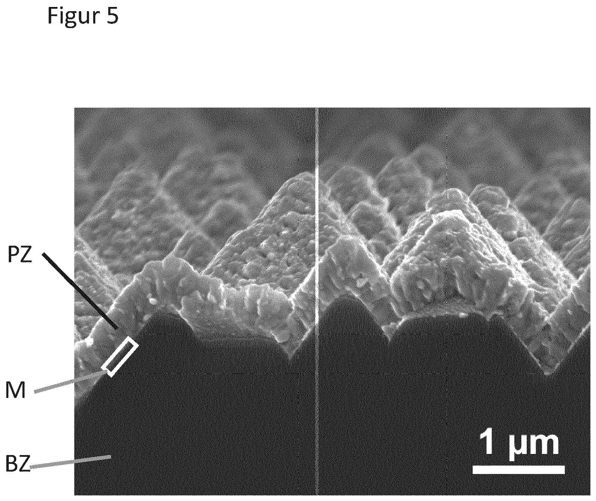

**Figur 5****:** Elektronenmikroskopisches Bild eines Querschnitts eines Perowskits, prozessiert über Ko-Verdampfen im Vakuum, gewachsen auf einem erfindungsgemäßen Multischichtsystem M bestehend aus ITO und V1193.

### Erstes Ausführungsbeispiel: CIGSe/Perowskit Tandem-Solarzelle mit rauer CIGSe-Oberfläche und Perowskit aus nasschemischer Prozessierung

Im ersten Ausführungsbeispiel ist das Multischichtsystem M gebildet aus einer Kombination von einer selbstorganisierten Monolage [2-(3,6-Dimethoxy-9*H*-carbazol-9-yl)ethyl]phosphonsäure, als V1193 bezeichnet, als Schicht A, in Verbindung mit Aluminium-dotiertem Zn-Oxid als Schicht B. Die Schicht A bedeckt dabei konform die Schicht B. Die Monolage kann in Figur 2 nicht einfach aufgelöst werden. Der Beweis für die Beschaffenheit liegt in der Änderung des Kontaktwinkels, wie es in dem Aufsatz 8 von A. Magomedov et al. (Adv. Ener. Mater., 8, 2018, 1801892 - 1-9). beschrieben ist und der hohen Leistungseffizienz der Tandemsolarzellen, denn nicht geschlossen bedeckte Oberflächen würden zu deutlich geringeren Effizienzen führen, wie auch dem Aufsatz 5 von M. Jost et al. zu entnehmen ist.

Das Multischichtsystem M des ersten Ausführungsbeispiels als Verbindungsschicht für eine Mehrfachsolarzelle ist zwischen einer CIGSe-Bottomzelle BZ und Perowskit-Topzelle PZ angeordnet und dient als Beispiel für einen Aufbau einer Mehrfachsolarzelle, wie in Figur 1 a) gezeigt. Die Bottomzelle BZ zeigt eine hohe Oberflächenrauigkeit in der Größenordnung von 200 - 400 nm (½ bis ¾ der Dicke der Perowskitschicht, welche ca. 400-600 nm dick ist), durch welche es nicht möglich ist mit konventionellen Methoden für hocheffiziente Perowskit-Solarzellen eine monolithische Tandemsolarzelle herzustellen. Die hier mit dem beschriebenen Multischichtsystem realisierte Tandemsolarzelle erreicht eine Leistungsumwandlungseffizienz von 21,6 %. Die Strom-Spannungskurve und eine elektronenmikroskopische Abbildung sind in Figur 2 gezeigt, die entsprechenden externen Quanteneffizienzen sind in Figur 3 zu sehen. Dieses Ergebnis zeigt die Leistungsstärke der erfindungsgemäßen Lösung eines Multischichtsystems M für eine Verbindungsschicht in Mehrfachsolarzellen und ist im Vergleich zu den bekannten Tandemsolarzellen, die entweder Polieren oder komplexe ALD-Schichten benötigen, wesentlich simpler und kostengünstiger, bei vergleichbarer Leistungsumwandlungseffizienz. Zudem kann das Multischichtsystem M ohne besondere Großgeräte oder Zusatz-Technologien auf größere Maßstäbe skaliert werden.

Im Folgenden ist das Herstellungsverfahren für V1193 als Beispiel für eine Molekülart gemäß der Formel (I) angegeben.

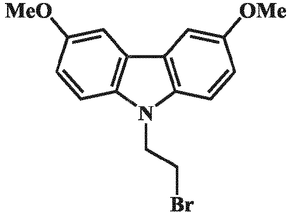

### 9-(2-Bromethyl)-3,6-dimethoxy-9H-carbazol (1)

3,6-Dimethoxycarbazol (0,534 g, 2,35 mmol) wurde in 1,2-Dibromethan (8 ml) gelöst und anschließend Tetrabuthylammoniumbromid (0,08 g, 0,25 mmol) mit 50%.iger wässriger KOH-Lösung (6,9 ml) zugegeben. Die Reaktion wurde bei 70 °C für 20 h (TLC, Aceton:n-Hexan, 3:22, Vol.:Vol.) gerührt. Nach Vervollständigung der Reaktion erfolgte die Extraktion mit Ethylacetat. Die organische Schicht wurde über wasserfreiem Na₂SO₄ getrocknet und das Lösungsmittel unter reduziertem Druck abdestilliert. Das ungereinigte Produkt wurde durch Säulenchromatographie unter Verwendung von Aceton:n-Hexan, 1:49, Vol.:Vol. als Elutionsmittel gereinigt, um 0,352 g (60 %) eines weißen kristallinen Materials - Verbindung **1** - zu erhalten.

Anal. Berechnet für C₁₆H₁₆O₂NBr, %: C 57,50; H 4,83: N 4,19; gefunden, %: C 57,39; H 4,86; N 4,15. **¹H NMR** (400 MHz, CDCl₃) δ 7,51 (d, *J =* 2,5 Hz, 2H), 7,29 (d, *J =* 8,8 Hz, 2H), 7,10 (dd, *J =* 8,8, 2,5 Hz, 2H), 4,62 (t, *J =* 7,5 Hz, 2H), 3,93 (s, 6H), 3,62 (t, *J =* 7,5 Hz, 2H). ¹³C NMR (101 MHz, CDCl₃) δ 153,85, 135,65, 123,39, 115,30, 109,41, 103,45, 56,27, 45,07, 28,55.

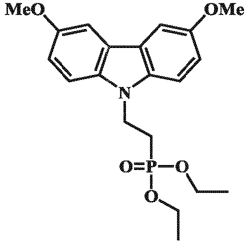

### Diethyl-[2-(3,6-dimethoxy-9H-carbazol-9-yl)ethyl]15hosphonate (2)

Die Verbindung **1** (0,316 g, 0,95 mmol) wurde in Triethylphosphit (2,7 mL) gelöst und das Reaktionsgemisch für 18 h unter Rückfluss erhitzt. Nach Beendigung der Reaktion (TLC, Aceton:n-Hexan, 1:4, Vol.:Vol.) wurde das Lösungsmittel unter reduziertem Druck abdestilliert. Das ungereinigte Produkt wurde durch Säulenchromatographie unter Verwendung von Aceton:n-Hexan, 1:1, Vol.:Vol. als Elutionsmittel gereinigt, um 0,353 g (95 %) einer klaren Flüssigkeit - Verbindung **2** - zu ergeben.

Anal. Berechnet für C₂₀H₂₆NO₅P, %: C 61,37; H 6,70; N 3,58; gefunden, %: C 61,32; H 6,73; N 3,55. **¹H NMR** (400 MHz, CDCl₃) δ 7,52 (d, *J =* 2,5 Hz, 2H), 7,30 (d, *J* = 8,8 Hz, 2H), 7,10 (dd, *J =* 8,8, 2,5 Hz, 2H), 4,60 - 4,49 (m, 2H), 4,09 - 4,03 (m, 4H), 3,93 (s, 6H), 2,29 - 2,15 (m, 2H), 1,28 (t, *J =* 7,1 Hz, 6H). **¹³C NMR** (101 MHz, CDCl₃) δ 153,67, 135,46, 123,37, 115,20, 109,49, 103,46, 62,02, 61,96, 56,28, 37,31, 26,15, 24,79, 16,56, 16,50.

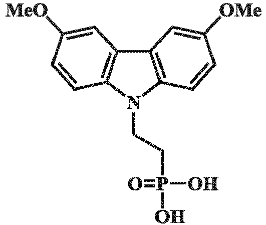

### [2-(3,6-Dimethoxy-9H-carbazol-9-yl)ethyl]phosphonsäure (3)

Verbindung **2** (0,335 g, 0,86 mmol) wurde in trockenem 1,4-Dioxan (25 mL) unter Argon gelöst. Anschließend wurde Bromtrimethylsilan (1,12 mL) tropfenweise zugegeben. Die Reaktion wurde für 24 h bei 25 °C unter einer Argonatmosphäre gehalten. Anschließend wurde das Lösungsmittel unter vermindertem Druck abdestilliert, der feste Rückstand in Methanol (15 mL) gelöst und destilliertes Wasser tropfenweise (30 mL) zugegeben, bis die Lösung undurchsichtig wurde, und dann 15 h lang gerührt. Das Produkt wurde abfiltriert und mit Wasser gewaschen, um 0,230 g (80 %) einer beigefarbenen Festsubstanz - Verbindung **3 (V1193)** - zu ergeben.

Anal. Berechnet für C₁₆H₁₈NO₅P, %: C 57,32; H 5,41; N 4,18, gefunden, %: C 57,19; H 5,53; N 4,11. **¹H NMR** (400 MHz, MeOD) δ 7,57 (d, *J =* 2,5 Hz, 2H), 7,34 (d, *J =* 8,8 Hz, 2H), 7,05 (dd, *J =* 8,8, 2,5 Hz, 2H), 4,58 - 4,48 (m, 2H), 3,87 (s, 6H), 2,20 - 2,06 (m, 2H). **¹³C NMR** (101 MHz, MeOD) δ 154,97, 136,71, 124,61, 116,03, 110,37, 104,29, 62,39, 56,46, 38,47.

Die Verfahrensschritte für ein Verfahren zur Herstellung des Multischichtsystems M des ersten Ausführungsbeispiels sind in einer mit Stickstoff-gefüllten Glovebox durchgeführt.

Die CIGSe-Bottomzelle BZ ist auf einem Glas-Substrat durch Vakuum-Deposition aufgebracht und entspricht im Wesentlichen der, wie sie in dem Aufsatz 9 von I. Repins et al. (Prog. Photovolt: Res. Appl., 16, 2008235-239) offenbart ist. Auf das Glas wird dabei zunächst Molybdän gesputtert, welches als p-Typ Elektrode dient. Die Bottomzelle BZ wird abgeschlossen durch eine nasschemisch prozessierte Cadmium-Sulfid-Schicht, worauf Schicht B, bestehend aus 10 nm Zink-Oxid und 140 nm Al-dotiertes Zink-Oxid, gesputtert wird. Weitergehend wird Schicht A auf Schicht B prozessiert.

Die Schicht A als SAM ist durch Eintauchen einer, mit UV-Ozon behandelten Schicht B, hier Al-dotiertes Zink-Oxid, in eine 0.1 mM/L-Lösung der V1193 Phosphonsäuremoleküle, gelöst in Ethanol, für etwa 12 h, gebildet. Die Schicht A ist dabei konform zur Schicht B. Das so entstandene Multischichtsystem M wurde aus der Lösung entfernt und im Folgenden bei 100 °C für 10 min getempert und anschließend mit Ethanol gewaschen.

Die Perowskitschicht der Perowskit-Mehrfachsolarzelle des Ausführungsbeispiels ist einem Tripelkation- Cs_{0.05}(MA_{0.17}FA_{0.83})_{0.95}Pb(I_{0.83}Br_{0.17})₃ Perowskit gebildet und ist gemäß dem folgenden Verfahren auf der Schicht A aufgebracht. Zunächst wird PbBr₂ und PbI₂ in Dimethylformamid:Dimethylsulfoxid (Volumenverhältnis 4:1) auf die Nennkonzentration von 1,5 M durch Schütteln über Nacht bei 60 °C gelöst. Anschließend wird die PbBr₂- und PbI₂-Stammlösungen zu Methylammomiumbromid (MABr)- bzw. Formamidiniumiodid (FAI)-Pulvern gegeben, um MAPbBr₃- und FAPbI₃-Lösungen mit einer Endkonzentration von 1,24 M zu erhalten. Das Molverhältnis zwischen Blei und den jeweiligen Kationen beträgt für beide Lösungen 1,09:1,00 (9 % Bleiüberschuss). MAPbBr₃- und FAPbI₃-Lösungen werden anschließend in einem Volumenverhältnis von 1:5 gemischt. Schließlich wird das Cäsiumkation aus einer 1,5 M CsI-Lösung in Dimethylsulfoxid (DMSO) im Volumenverhältnis 5:95 zugegeben.

Die Vorläuferlösung wird unter Verwendung des folgenden Programms durch Rotationsbeschichtung oben auf die Schicht A abgeschieden: 3.500 U/min (5 s Beschleunigung) für 35 s (Gesamtzeit - 40 s). Nach 35 s wird 200 µl Chlorbenzol (alternativ Anisol, oder Ethylacetat nach 25 s) auf das sich drehende Substrat gegossen. Nach dem Rotationsbeschichtungs-Programm wird die mit Perowskit beschichtete Mehrfachsolarzelle für 60 min auf einer Heizplatte bei 100°C getempert.

Auf das Perowskit wird, zur Komplettierung der Mehrfachsolarzelle, 20 nm C60 (Fulleren) durch thermische Verdampfung (Mbraun ProVap 3G) mit Verdampfungsraten von ca. 0,1 bis 0,3 Å/s bei einem Basisdruck von unter 1E-6 mbar abgeschieden. Anschließend wird auf das C60 eine etwa 20 nm dicke Sn-Oxidschicht durch ALD (engl. atomic layer depostion) abgeschieden. Schließlich wird etwa 120 nm Indium-dotiertes Zink-Oxid auf die Probe gesputtert. Um die Solarzelle abzuschließen wird ein 100 nm dicker Silber-Rahmen um die aktive Fläche thermisch aufgedampft und eine 100 nm dicke Antireflektionsbeschichtung aus LiF auf die aktive Fläche. Das C60/SnOx/IZO/Ag Schichtsystem stellt den "Topkontakt" T dar.

**Zweites Ausführungsbeispiel:** Silizium/Perowskit Tandem-Solarzelle mit polierter Si-Oberfläche und Perowskit aus Vakuum-Abscheidung, wie sie einem Aufbau einer Mehrfachsolarzelle der Figur 1 b) entspricht.

Das zweite Ausführungsbeispiel zeigt, dass das Multischichtsystem M auch in einer Tandemsolarzelle hocheffizient funktioniert, die aus anderen Komponenten besteht als die in dem ersten Ausführungsbeispiel gezeigten. Hierbei wird die Bottomzelle BZ durch eine Silizium-Solarzelle repräsentiert, Schicht B durch Zinn-dotiertes Indium-Oxid (ITO), Schicht A durch V1193 und die Topzelle PZ aus einem "Einzel-Kation"-Perowskit - Methylammonium-Bleiiodid (MAPbI₃) - der durch Ko-Verdampfen im Vakuum hergestellt wird. Dabei wird die Perowskit-Schicht gebildet aus gleichzeitigem Verdampfen von Bleiiodid und Methylammoniumiodid. Anschließend wird der Topkontakt T wie im ersten Ausführungsbeispiel prozessiert, um die Tandem-Solarzelle zu komplettieren.

Die Bottomzelle BZ ist eine Silizium-Heteroübergang-Solarzelle (engl. *silicon heterojunction solar cell*), fabriziert aus einem 260 µm dicken <100> n-Typ kristallinen Si-Wafer. Die Rückseite wird nasschemisch zu pyramidalen Texturen geätzt; die Frontseite wird poliert belassen. Der Wafer wird zunächst von nativem Si-Oxid befreit und anschließend 5 nm amorphes Si (a-Si:H) zur Passivierung abgeschieden. Auf der texturierten Rückseite wird 5 nm, p-dotiertes a-Si:H abgeschieden. Die Frontseite wird anschließend mit 95 nm n-dotiertem nanokristallinem Si-Oxid (ns-SiOx:H) beschichtet. Die Rückelektrode wird durch eine ZnO:Al/Ag Schicht auf der Rückseite dargestellt. Die Frontelektrode (Schicht B) wurde durch Sputtern von 20 nm ITO prozessiert. Schicht A wurde in diesem Beispiel durch Rotationsbeschichtung einer 1 mM/l konzentrierten Ethanol-Lösung von V1193 auf Schicht B prozessiert. Dafür wurde 100 µl auf das Substrat gegossen bei 3000 Umdrehungen pro Minute. Anschließend wurde das Substrat für 10 min bei 100 °C ausgeheizt. Ein Waschen fand anschließend nicht statt. Schicht A ist auch hier konform zu Schicht B.

Die Prozessierung der Perowskit-Teil-Solarzelle PZ erfolgt durch Vakuum-Abscheidung, wie es in dem Aufsatz 10 von M. Liu et al. (Nature, 501, 2013, 395-398) beschrieben ist.

Figur 4 zeigt die Stromdichte-Spannungs-Kennlinie der Tandemsolarzelle des zweiten Ausführungsbeispiels und ein elektronenmikroskopisches Bild des Querschnitts der Solarzelle.

**Drittes Ausführungsbeispiel:** Vakuum-Abscheidung von Perowskit auf texturiertem Silizium entsprechend einem Aufbau einer Mehrfachsolarzelle, wie sie in Figur 1 c) gezeigt ist.

Eine weitere wichtige Anwendung der Erfindung ist die konforme Abdeckung von texturierten Substraten, wie z.B. pyramidal texturiertes Silizium. Figur 5 zeigt Perowskit PZ, prozessiert über Ko-Verdampfen im Vakuum, gewachsen auf einem Multischichtsystem (M) bestehend aus ITO und V1193. Die Schicht B des Multischichtsystems wurde wie in dem zweiten Ausführungsbeispiel durch Sputtern von ITO prozessiert. Schicht A (V1193 SAM) wurde wie in dem ersten Ausführungsbeispiel durch Eintauchen des Substrates in die V1193-Lösung prozessiert. Die Konformität der Schicht A zu der Schicht B ist hierbei durch das unterbrechungsfreie und gleichmäßige Wachstum des Perowskits auf der SAM Oberfläche ersichtlich.

### Liste der Abkürzungen

| | **Englische Bezeichnung** | **Deutsche Bezeichnung** |
|---|---|---|
| PCE | power conversion efficiency | Wirkungsgrad der Leistungsumwandlung |
| TCO | transparent conductive oxide | Transparentes, leitfähiges Oxid |
| HTM | hole transporting material | Lochleitendes Material |
| AZO | aluminum doped zinc oxide | Aluminium-dotiertes Zinkoxid |
| SAM | self-assembling monolayer | Selbstorganisierende Monolage |
| HTF | hole transporting fragment | Lochleitendes Fragment |
| FM | filler molecule | Füllstoffmolekül |
| CIGSe | Cupper, Indium, Gallium Selenide | Kupfer, Indium, Gallium, Selenid |
| a-Si:H | amorphous Silicon, Hydrogen-terminated | amorphes Silizium, Wasserstoff-terminiert |
| nc-Si:H | nanocrystalline Silicon, Hydrogen-terminated | nanokristallines Silizium, Wasserstoff-terminiert |
| µc-Si:H | microcrystalline Silicon, Hydrogen-terminated | mikrokristallines Silizium, Wasserstoff-terminiert |
| SiOx | silicon oxide | Siliziumoxid |
| nc-SiOx:H | nanocrystalline Silicon oxide, Hydrogen-terminated | nanokristallines Siliziumoxid, Wasserstoff-terminiert |
| µc-SiOx:H | microcrystalline Silicon oxide, Hydrogen-terminated | mikrokristallines Siliziumoxid, Wasserstoff-terminiert |
| a-SiOx:H | amorphous Silicon oxide, Hydrogen-terminated | amorphes Siliziumoxid, Wasserstoff-terminiert |
| T-BAG | tethering by aggregation and growth | Anbindung durch Aggregation und Wachstum |
| ITO | Indium tin oxide | Indium-Zinn-Oxid |
| SnOx | tin oxide | Zinn-Oxid |
| IZO | Indium zinc oxide | Indium-Zink-Oxid |
| LiF | lithium fluoride | Lithium-Fluorid |

## Patentansprüche

1. Mehrfachsolarzelle umfassend mindestens eine Perowskit-Teil-Solarzelle (PZ), und ein Multischichtsystem (M), wobei das Multischichtsystem mindestens zwei Schichten, Schicht A und Schicht B umfasst, wobei Schicht A direkt konform auf Schicht B aufgebracht und wobei die Perowskit-Teil-Solarzelle (PZ) direkt auf die Schicht A und die Schicht B direkt auf eine Bottomzelle (BZ) der Mehrfachsolarzelle aufgebracht sind;
**dadurch gekennzeichnet, dass** die
Schicht A aus mindestens einer Molekülart gemäß der Formel (I) ausgewählt wird, 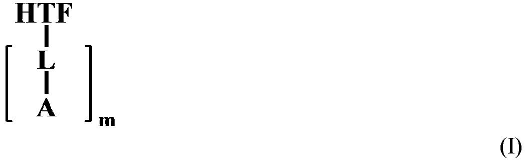
mit m = 1 bis 2, wobei L ein verbindendes Fragment, A eine Ankergruppe und HTF ein lochleitendes Fragment ist (engl. hole transporting fragment, lochleitendes Fragment), das aus einer der folgenden Formeln (II) oder (III) ausgewählt ist, einem Polyzyklus
Z-D-Z (II)
wobei Formel (II) ausgewählt ist aus mindestens einer der Formeln IV bis XIII: 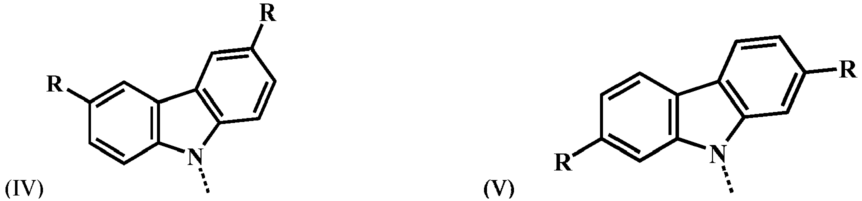 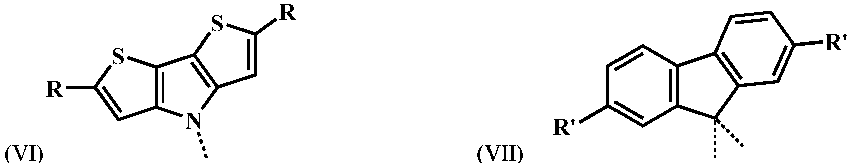 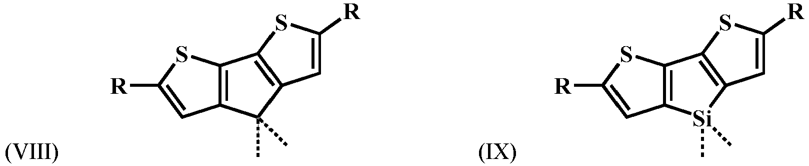 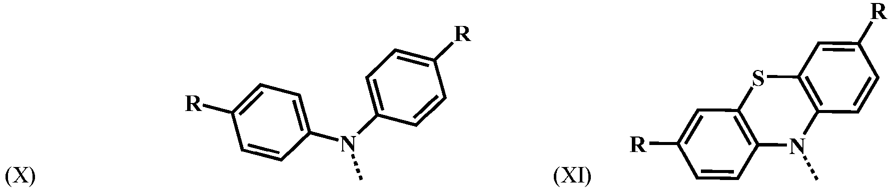 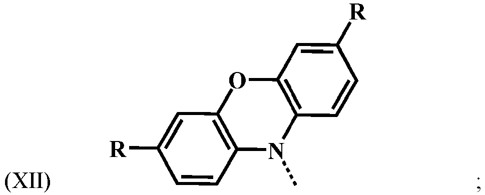 ; oder 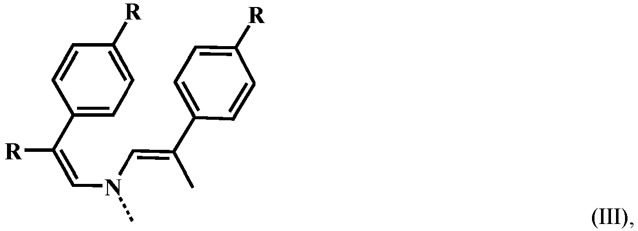
insbesondere ausgewählt aus einer der Formeln (XIII) und (XIV) 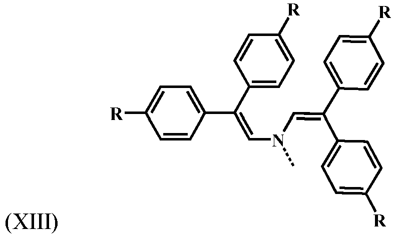 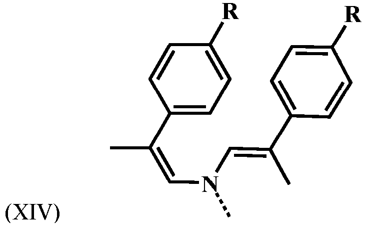
und R ein Substituent, unabhängig voneinander ausgewählt aus Wasserstoff oder 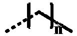 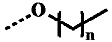 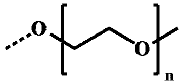 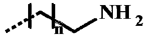 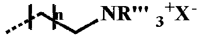 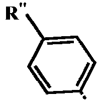
wobei
n = 1 bis 12 und die gestrichelten Linien die Bindung darstellen, durch die R mit dem HTF gemäß Formel (II) oder (III) verbunden ist, X Halogen (F, Cl, Br, I) darstellt;
R‴ Wasserstoff, Alkyl (C₁ bis C₁₂) darstellt und/oder R" Wasserstoff, Alkyl, Alkoxy (-CH₃; -OCH₃) darstellt, als selbstorganisierte Monolage gebildet ist und Schicht B aus mindestens einem der Materialien der Gruppe Indium-, Zink-, Zinn-, Nickel-, Kupfer-, Wolfram- und Molybdänoxid oder Mischungen davon oder Siliziumoxid oder Silizium, inklusive amorpher, nano- oder multikristalliner, Wasserstoff-dotierter und oxydischer Schichten, insbesondere a-Si:H, nc-Si:H, a-SiOx:H, nc-SiOx:H, mc-Si:H, mc-SiOx:H gebildet ist**.**

## Claims

1. A multi-junction solar cell comprising at least one perovskite sub-solar cell (PZ), and a multilayer system (M), wherein the multilayer system comprises at least two layers, layer A and layer B, wherein layer A is applied directly and conformally onto layer B, and wherein the perovskite sub-solar cell (PZ) is applied directly onto layer A, and layer B is applied directly onto a bottom cell (BZ) of the multi-junction solar cell;
**characterised in that** layer A is selected from at least one of a molecular species according to formula (I), 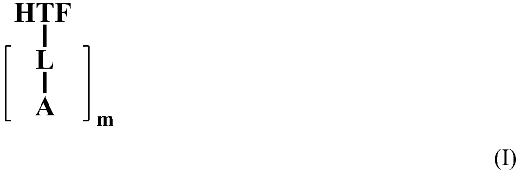
wherein m = 1 to 2, L is a linking moiety, A is an anchor group and HTF is a hole-transporting fragment selected from one of the following formulae (II) or (III), a polycyclic compound
Z-D-Z (II)
wherein formula (II) is selected from at least one of formulas IV to XIII: 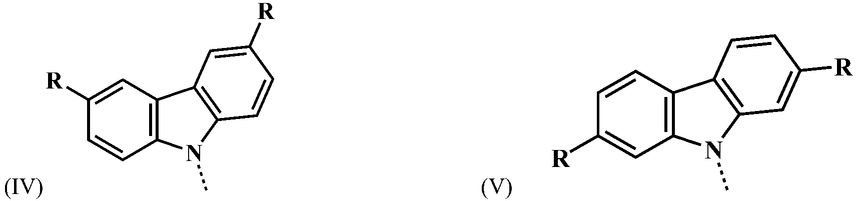 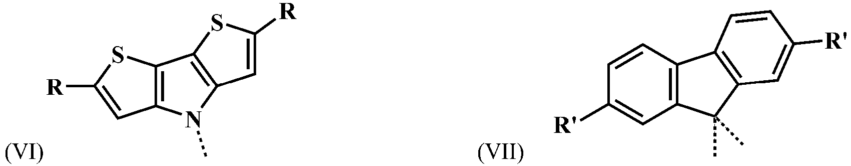 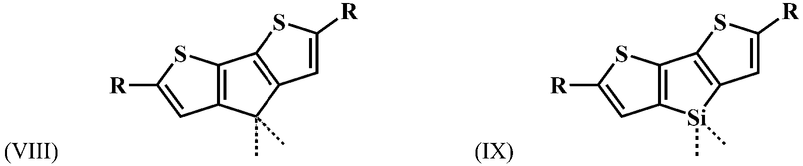 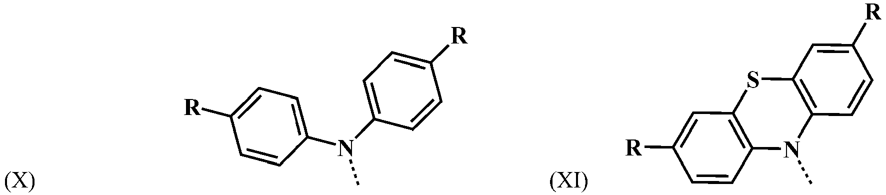 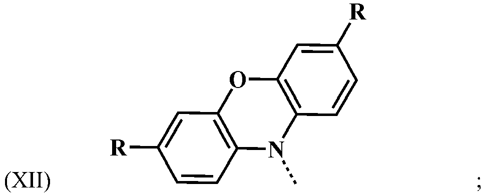 ; or 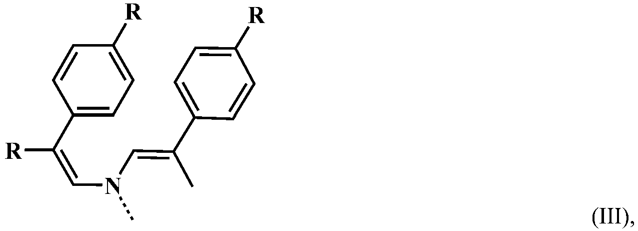
in particular selected from one of formulae (XIII) and (XIV) 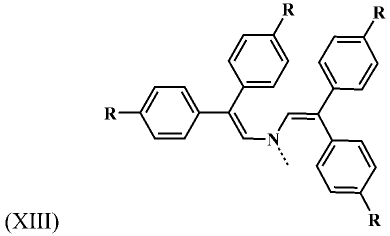 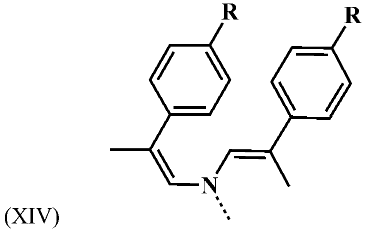
and R is a substituent, independently selected from hydrogen or 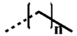 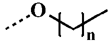 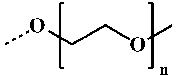 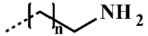 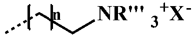 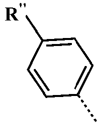
wherein
n = 1 to 12 and the dotted lines represent the bond through which R is linked to the HTF according to formula (II) or (III), X represents a halogen (F, Cl, Br, I);
R‴ represents hydrogen, alkyl (C₁ to C₁₂) and/or R'' represents hydrogen, alkyl, alkoxy (-CH₃; -OCH₃), formed as a self-assembled monolayer, and layer B is formed of at least one of the materials from the group of indium, zinc, tin, nickel, copper, tungsten and molybdenum oxides or mixtures thereof, or silicon oxide or silicon, including amorphous, nano- or multi crystalline, hydrogen-doped and oxidic layers, in particular a-Si:H, nc-Si:H, a-SiOx:H, nc-SiOx:H, mc-Si:H, mc-SiOx:H.

## Revendications

1. Cellule photovoltaïque multiple comprenant au moins une cellule photovoltaïque partielle à pérovskite (PZ), et un système multicouche (M), dans laquelle le système multicouche comprend au moins deux couches, couche A et couche B, dans laquelle la couche A est directement appliquée de manière conforme sur la couche B et dans laquelle la cellule photovoltaïque partielle à pérovskite (PZ) est directement appliquée sur la couche A et la couche B directement sur une cellule inférieure (BZ) de la cellule photovoltaïque multiple ;
**caractérisée en ce que**
la couche A est sélectionnée parmi au moins un type de molécule selon la formule (I) 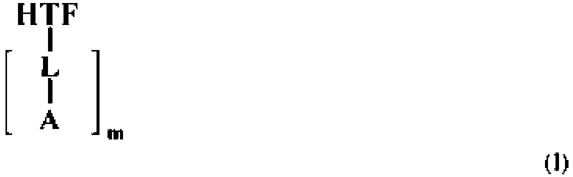
avec m = 1 à 2, dans laquelle L est un fragment de liaison, A est un groupe d'ancrage et HTF est un fragment de transport de trous (en anglais hole transporting fragment, fragment de transport de trous) qui est sélectionné parmi une des formules suivantes (II) ou (III), un polycycle
Z-D-Z (II)
dans laquelle la formule (II) est sélectionnée parmi au moins une des formules IV à XIII : 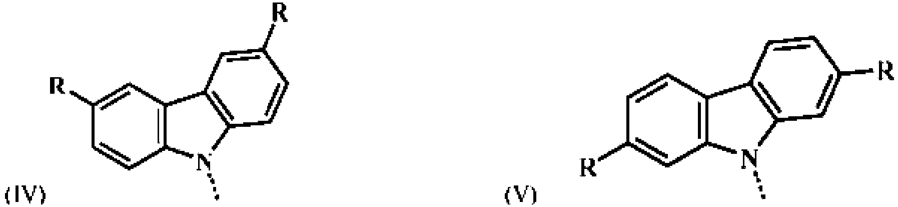 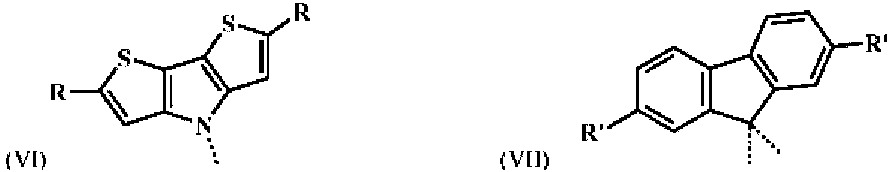 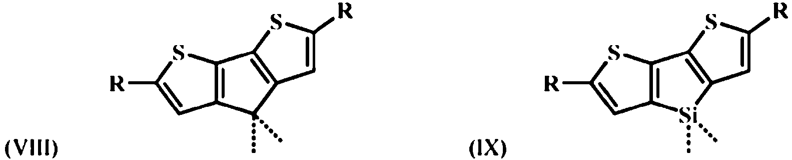 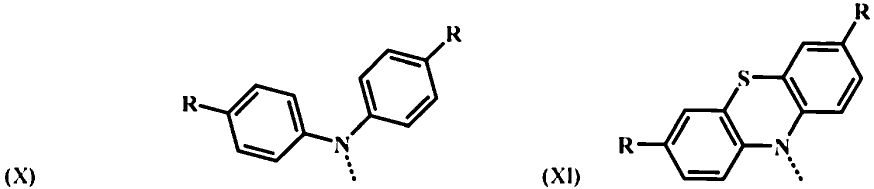 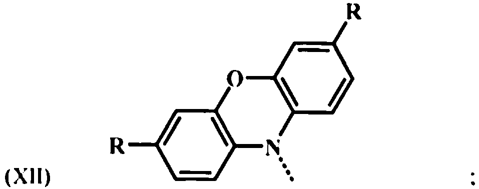 ou 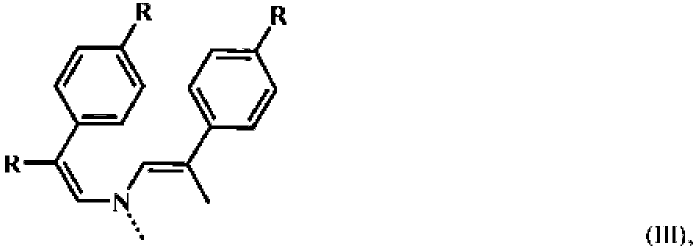
notamment sélectionnée parmi une des formules (XIII) et (XIV) 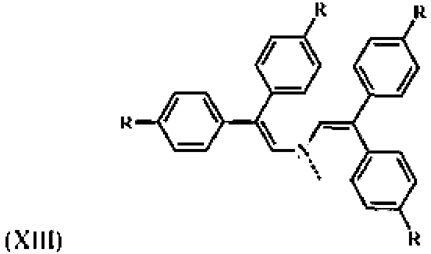 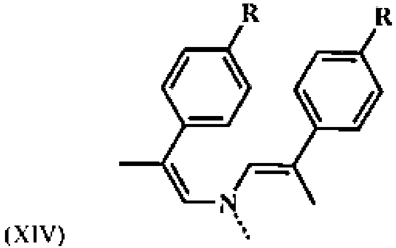
et R est un substituant, indépendamment l'un de l'autre sélectionné parmi hydrogène ou 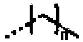 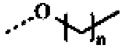 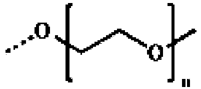 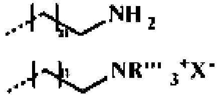 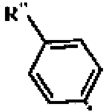
dans laquelle
n = 1 à 12 et les lignes en pointillés représentent la liaison par laquelle R est relié au HFT selon la formule (II) ou (III), X représente halogène (F, CI, Br, I) ;
R"' représente hydrogène, alkyle (C₁ à C₁₂) et/ou R" représente hydrogène, alkyle, alcoxy (-CH₃ ; -OCH₃), est formée en tant que monocouche à organisation autonome et la couche B est formée à partir d'au moins un des matériaux du groupe oxyde d'indium, de zinc, d'étain, de nickel, de cuivre, de tungstène et de molybdène ou des mélanges de ceux-ci ou d'oxyde de silicium ou de silicium, y compris des couches amorphes, nano- ou multicristallines, dopées à l'hydrogène et oxydées, notamment a-Si/H, nc-Si/H, a-SiOx/H, nc-SiOx/H, mc-Si/H, mc-SiOx/H.
